# EUROPÄISCHE PATENTSCHRIFT

(11) **EP 1 142 019 B1**
(45) Veröffentlichungstag und Bekanntmachung des Hinweises auf die Patenterteilung: **23.01.2008**
(21) Anmeldenummer: 99966819.7
(22) Anmeldetag: 01.12.1999
(51) Int. Cl.: H01L 27/06, H01L 29/76

(54) **SCHALTUNGSANORDNUNG MIT MINDESTENS EINEM NANOELEKTRONISCHEN BAUELEMENT UND VERFAHREN ZU DEREN HERSTELLUNG**
CIRCUIT ASSEMBLY WITH AT LEAST ONE NANOELECTRONIC COMPONENT AND METHOD FOR PRODUCING THE SAME
CIRCUIT COMPRENANT AU MOINS UN COMPOSANT NANO-ELECTRONIQUE ET PROCEDE PERMETTANT DE LE PRODUIRE

(30) Priorität: 18.12.1998 DE 19858759
(43) Veröffentlichungstag der Anmeldung: 10.10.2001
(73) Patentinhaber: Infineon Technologies AG, 81669 München (DE)
(72) Erfinder: RÖSNER, Wolfgang, D-81739 München (DE); RAMCKE, Ties, D-80798 München (DE); RISCH, Lothar, D-85579 Neubiberg (DE)
(74) Vertreter: Kottmann, Heinz Dieter
(86) Internationale Anmeldenummer: PCT/DE1999/003831
(87) Internationale Veröffentlichungsnummer: WO 2000/038235

(56) Entgegenhaltungen:
- EP-A- 0 844 671
- US-A- 4 902 637
- US-A- 5 754 077
- KRISHNAMOORTHY A V ET AL: "3-D INTEGRATION OF MQW MODULATORS OVER ACTIVE SUBMICRON CMOS CIRCUITS: 375 MB/S TRANSIMPEDANCE RECEIVER-TRANSMITTER CIRCUIT" IEEE PHOTONICS TECHNOLOGY LETTERS,US,IEEE INC. NEW YORK, Bd. 7, Nr. 11, 1. November 1995 (1995-11-01), Seiten 1288-1290, XP000537957 ISSN: 1041-1135
- CHO D H ET AL: "INTERCONNECT CAPACITANCE, CROSSTALK, AND SIGNAL DELAY FOR 0.35 MUM CMOS TECHNOLOGY" INTERNATIONAL ELECTRON DEVICES MEETING (IEDM),US,NEW YORK, IEEE,1996, Seiten 619-622, XP000753819 ISBN: 0-7803-3394-2
- CHEN C D ET AL: "ALUMINUM SINGLE-ELECTRON NONVOLATILE FLOATING GATE MEMORY CELL" APPLIED PHYSICS LETTERS,US,AMERICAN INSTITUTE OF PHYSICS. NEW YORK, Bd. 71, Nr. 4, 6. Oktober 1997 (1997-10-06), Seiten 2038-2040, XP000725852 ISSN: 0003-6951
- MATSUMOTO K: "ROOM TEMPERATURE OPERATED SINGLE ELECTRON TRANSISTOR BY STM NANO-OXIDATION PROCESS: FABRICATION PROCESS AND ELECTRICAL PROPERTIES" IEICE TRANSACTIONS ON ELECTRONICS,JP,INSTITUTE OF ELECTRONICS INFORMATION AND COMM. ENG. TOKYO, Bd. E79-C, Nr. 11, 1. November 1996 (1996-11-01), Seiten 1509-1514, XP000681549 ISSN: 0916-8524
- SHIRAKASHI J -I ET AL: "FABRICATION AND CHARACTERIZATION OF NB/NB OXIDES-BASED SINGLE ELECTRON TRANSISTORS (SETS)" INTERNATIONAL CONFERENCE ON SOLID STATE DEVICES AND MATERIALS,JA,JAPAN SOCIETY OF APPLIED PHYSICS. TOKYO, Bd. CONF. 1996, 1. Januar 1996 (1996-01-01), Seiten 440-442, XP000694065

## Beschreibung

Die Erfindung betrifft eine Schaltungsanordnung mit mindestens einem nanoelektronischen Bauelement und ein Verfahren zu deren Herstellung.

Um eine Schaltungsanordnung mit immer höherer Packungsdichte zu erzeugen, werden Abmessungen eines Bauelements der Schaltungsanordnung vermutlich schon in absehbarer Zeit nur noch wenige Nanometer betragen. Ein solches sogenanntes nanoelektronisches Bauelement ist beispielsweise ein Einzelelektron-Bauelement, in dem Schaltungsvorgänge durch einzelne Elektronen realisiert werden.

In C. D. Chen et al, "Aluminium single-electron nonvolatile floating gate memory cell", Appl. Phys. Lett. 71 (14) (1997) 2038 wird ein Einzelelektron-Transistor beschrieben, der im wesentlichen aus Aluminium erzeugt wird.

Nanoelektronische Bauelemente können auch biologische Nervenzellen oder molekularelektronische Strukturen sein (siehe z.B. C.M. Fischer et al, "Organic Quantum Wells: Molecular Rectification and Single-Electron Tunnelling", Europhys. Lett. 28, 129 (1994)).

Im allgemeinen werden nanoelektronische Bauelemente vorgeschlagen, die in einer ganz anderen Technik hergestellt werden als die herkömmlichen CMOS-Bauelemente.

In F. G. Pikus et al, "Nanoscale field-effect transistors: An ultimate size analysis", Appl. Phys. Lett. 71 (25) (1997) 3661, wird ein nanoelektronisches CMOS-Bauelement untersucht.

Aus K. Yano et al, "A Room-Temperature Single-Electron Memory Device Using Fine-Grain Polycrystalline Silicon", IEDM (1993) 541, ist eine nanoelektronische Speicherzelle bekannt, die aus einem Transistor besteht. Source-, Drain- und Kanalgebiet des Transistors werden durch Strukturierung einer 4 nm dicken amorphen Siliziumschicht erzeugt. Körner der Siliziumschicht weisen horizontale Abmessungen von ca. 10 nm auf. Das Kanalgebiet und eine Gateelektrode des Transistors sind mit SiO₂ umgeben. Wird der Transistor bei niedrigem Strom betrieben, so bildet sich ein enger Kanal im Kanalgebiet aus, der aus einer Kette von Körnern, zwischen denen einzelne Elektronen tunneln, besteht. Die Einsatzspannung des Transistors kann analog zu einem EEPROM geändert werden, was einer Programmierung der Speicherzelle entspricht. Zum Programmieren z.B. einer logischen 1 wird die Spannung an der Gateelektrode, die als Kontroll-Gateelektrode wirkt, soweit erhöht, dass Elektronen auf Körner des Kanalgebiets hüpfen, die außerhalb des Kanals liegen, und dort bleiben. Die geladenen Körner wirken analog zu einer Floating-Gateelektrode des EEPROM's, so dass sich die Einsatzspannung des Transistors verändert.

Schließlich ist aus der EP-A-0 844 671 eine Schaltungsanordnung mit mindestens einem nanoelektronischen Bauelement bekannt, bei der mindestens ein CMOS-Bauelement Teil der Schaltungsanordnung ist und in einem Halbleitersubstrat angeordnet ist. Auf dem Halbleitersubstrat ist eine isolierende Schicht vorgesehen, die das CMOS-Bauelement bedeckt. Über dieser isolierenden Schicht ist das nanoelektronische Bauelement angeordnet, wobei in der isolierenden Schicht eine leitende Struktur vorgesehen ist, die der Verbindung des nanoelektronischen Bauelements mit dem CMOS-Bauelement dient. Weiterhin sind über der isolierenden Schicht weitere nanoelektronische Bauelemente vorgesehen, die zu Nano-Schaltblöcken gruppiert sind, wobei jeder Nano-Schaltblock Leitungen umfasst, die die nanoelektronischen Bauelemente des Nano-Schaltblocks untereinander verbinden. Das CMOS-Bauelement ist Teil einer CMOS-Schaltung, die im Halbleitersubstrat angeordnet ist. Diese CMOS-Schaltung bildet eine erste Ansteuerschaltung für die Nano-Schaltblöcke, und eine zweite Ansteuerschaltung ist zwischen den Nano-Schaltblock und die CMOS-Schaltung geschaltet.

Der Erfindung liegt das Probem zugrunde, eine weitere Schaltungsanordnung mit mindestens einem nanoelektronischen Bauelement anzugeben. Ferner soll ein Verfahren zu deren Herstellung angegeben werden.

Diese Aufgabe wird erfindungsgemäß durch eine Schaltungsanordnung mit den Merkmalen des Patentanspruches 1 bzw. durch ein Verfahren mit den Merkmalen des Patentanspruches 6 gelöst.

Die Erfindung schafft also eine Schaltungsanordnung mit mindestens einem nanoelektronischen Bauelement, bei der mindestens ein CMOS-Bauelement Teil der Schaltungsanordnung ist und in einem Halbleitersubstrat angeordnet ist. Auf dem Halbleitersubstrat ist eine isolierende Schicht angeordnet, die das CMOS-Bauelement bedeckt. Über der isolierenden Schicht ist das nanoelektronische Bauelement angeordnet, die das CMOS-Bauelement bedeckt. Über der isolierenden Schicht ist das nanoelektronische Bauelement angeordnet. In der isolierenden Schicht ist mindestens eine leitenden Struktur angeordnet, die der Verbindung des nanoelektronischen Bauelements mit dem CMOS-Bauelement dient.

Das Problem wird ferner gelöst durch ein Verfahren zur Herstellung einer Schaltungsanordnung mit mindestens einem nanoelektronischen Bauelement, bei dem in einem Halbleitersubstrat mit einem CMOS-Verfahren mindestens ein CMOS-Bauelement erzeugt wird, das Teil der Schaltungsanordnung ist. Nach Erzeugung des CMOS-Bauelements wird eine isolierende Schicht auf dem Halbleitersubstrat aufgebracht, die das CMOS-Bauelement bedeckt. In der isolierenden Schicht wird eine leitende Struktur erzeugt und mit dem CMOS-Bauelement verbunden. Über der isolierenden Schicht wird mit einer Nano-Strukturierungstechnik das nanoelektronische Bauelement erzeugt, so daß es über die leitende Struktur mit dem CMOS-Bauelement verbunden ist.

Die Schaltungsanordnung weist eine hohe Packungsdichte auf, da das CMOS-Bauelement unter dem nanoelektronischen Bauelement angeordnet ist.

Die Erfindung ermöglicht die Integration von nanoelektronischen Bauelementen in mikroelektronische Produkte.

Da das nanoelektronische Bauelement erst nach Erzeugung des CMOS-Bauelements erzeugt wird, wird es durch die Verfahrensschritte zur Erzeugung des CMOS-Bauelements nicht angegriffen. Die Nano-Strukturierungstechnik kann verschieden von den herkömmlichen CMOS-Verfahren sein.

Die Schaltungsanordnung umfasst weitere nanoelektronische Bauelemente. Zur Erhöhung der Packungsdichte sind die nanoelektronischen Bauelemente möglichst dicht nebeneinander angeordnet. Bei einer gegebenen Zahl von nanoelektronischen Bauelementen, die untereinander durch Leitungen verbunden sind, bewirkt die dichte Anordnung eine Verkürzung der Leitungen. Dies ist vorteilhaft, da Widerstände der Leitungen reduziert werden. Zum einen bedeutet dies weniger Energieverlust in der Schaltungsanordnung. Zum anderen ist das Produkt aus dem Widerstand und der Kapazität der Leitungen, die sogenannte RC-Zeit, ebenfalls klein, so daß Änderungen der Spannungen der Leitungen schneller stattfinden, und die Schaltungsanordnung schneller schaltet.

Um trotz großer Zahl an nanoelektronischen Bauelementen kurze Leitungen zu realisieren, ist es vorteilhaft, dass die nanoelektronischen Bauelemente zu Nano-schaltblöcken gruppiert sind. Ein Nano-Schaltblock ist eine Anordnung von beieinander liegenden nanoelektronischen Bauelementen, die durch Leitungen mit nanometer-breiten Querschnitten untereinander verbunden sind. Durch die Gruppierung vergrößert sich zwar die Zahl der Leitungen der Schaltungsanordnung, doch sind die Leitungen dafür kürzer. Die Gruppierung erleichtert darüber hinaus die Wärmeabfuhr aus der Schaltungsanordnung.

Die Nano-Schaltblöcke sind jeweils so klein, daß die RC-Zeiten ihrer Leitungen nicht größer als 1ns sind. Die Nano-Schaltblöcke sind über die leitende Struktur und weitere in der isolierenden Schicht angeordnete leitende Strukturen mit einer CMOS-Schaltung verbunden, die das CMOS-Bauelement umfaßt. Vorzugsweise ist jeder Nano-Schaltblock über mindestens eine der leitenden Strukturen mit der CMOS-Schaltung verbunden. Hier zeigt sich ein weiterer Vorteil der Erfindung: Da die CMOS-Schaltung unter den Nano-Schaltblöcken angeordnet ist und nicht beispielsweise daneben, verlaufen die leitenden Strukturen nicht in einer zweidimensionalen Ebene, in der die Nano-Schaltblöcke angeordnet sind, sondern mindestens teilweise senkrecht zu dieser Ebene. Die leitenden Strukturen haben folglich mehr Platz, so daß die Nano-Schaltblöcke in geringen Abständen voneinander angeordnet werden können, was zu einer größeren Packungsdichte führt. Gerade beim Gruppieren der nanoelektronischen Bauelemente zu mehreren Nano-Schaltblöcken kann es wichtig sein, daß die leitenden Strukturen viel Platz zur Verfügung haben. Viele kleine Nano-Schaltblöcke erfordern nämlich in der Regel eine größere Zahl an leitenden Strukturen als ein großer Nano-Schaltblock, da jeder der Nano-Schaltblöcke separat mit der CMOS-Schaltung verbunden wird.

Die CMOS-Schaltung ist eine erste Ansteuerschaltung für die Nano-Schaltblöcke.

Um die Zahl der leitenden Strukturen, die mit den Nano-Schaltblöcken verbunden sind, zu reduzieren, ist es vorteilhaft, dass angrenzend an jeden Nano-Schaltblock eine zweite Ansteuerschaltung angeordnet ist, die zwischen den Nano-Schaltblock und die erste Ansteuerschaltung geschaltet ist. Die zweite Ansteuerschaltung faßt die Leitungen im Nano-Schaltblock so zusammen, daß die Zahl der leitenden Strukturen, die mit der zweiten Ansteuerschaltung verbunden sind, kleiner ist als die Zahl der Leitungen. Die leitenden Strukturen verbinden die erste Ansteuerschaltung mit den zweiten Ansteuerschaltungen. Ein solcher hierarchischer Aufbau verkleinert die Dichte der leitenden Strukturen, so daß die CMOS-Schaltung in entspannten Dimensionen erzeugt werden kann. Die zweite Ansteuerschaltung kann z.B. mit der Nano-Strukturierungstechnik erzeugt werden, mit der die Nano-Schaltblöcke erzeugt werden.

Die Nano-Schaltblöcke können beispielsweise Speicherzellen-Anordnungen sein. Eine Speicherzelle kann beispielsweise wie eine Speicherzelle gemäß C. D. Chen et al (s. o.) ausgestaltet sein. Die zweite Ansteuerschaltung umfaßt beispielsweise Einzelelektronen-Transistoren. Die zweite Ansteuerschaltung kann beispielsweise Bitleitungen des Nano-Schaltblocks so zusammenfassen, daß Signale der Bitleitungen sequentiell an die erste Ansteuerschaltung weitergeleitet werden. Mit der ersten Ansteuerschaltung wird bestimmt, welcher der Nano-Schaltblöcke adressiert wird.

Zur Verbindung von CMOS-Bauelementen der CMOS-Schaltung untereinander und mit den Nano-Schaltblöcken können in der ersten isolierenden Schicht eine oder mehrere Metallisierungsebenen angeordnet sein, die Teil der leitenden Strukturen sind. Kontakte, die ebenfalls Teile der leitenden Strukturen sind, sind in der isolierenden Schicht angeordnet und verbinden die erste Ansteuerschaltung mit der Metallisierungsebene oder die Metallisierungsebene mit den zweiten Ansteuerschaltungen.

Die Metallisierungsebene kann erzeugt werden, indem zunächst ein unterer Teil der isolierenden Schicht aufgebracht wird. In dem unteren Teil der isolierenden Schicht werden erste der Kontakte erzeugt, die an die CMOS-Schaltung angrenzen. Auf dem unteren Teil der isolierenden Schicht wird die Metallisierungsebene erzeugt, indem leitendes Material aufgebracht und strukturiert wird. Anschließend wird ein oberer Teil der isolierenden Schicht aufgebracht. In dem oberen Teil der isolierenden Schicht werden zweite der Kontakte erzeugt, die an die Metallisierungsebene angrenzen. Die Nano-Schaltblöcke werden so erzeugt, daß sie mit den zweiten Kontakten verbunden werden.

Die isolierende Schicht kann in mehr als zwei Teilen aufgebracht werden, so daß mehrere Kontakte und mehrere Metallisierungsebenen erzeugt werden können.

Ein Teil der Leitungen des Nano-Schaltblocks kann Teil einer Nano-Metallisierungsebene sein, die in der isolierenden Struktur angeordnet ist. Eine Nano-Metallisierungsebene ist eine Metallisierungsebene, deren Leitungen und Kontakte Abmessungen von wenigen Nanometern aufweisen. Das Vorsehen einer solchen Metallisierungsebene ermöglicht die Kreuzung der Leitungen des Nano-Schaltblocks.

Zur Erzeugung des nanoelektronischen Bauelements kann auf der isolierenden Schicht eine Schicht aufgebracht und strukturiert werden. Die Schicht enthält z.B. Aluminium und wird, wie in C.D. Chen (s.o.) erläutert, bearbeitet.

Die Schicht kann auch aus Titan oder Niob bestehen. In diesem Fall kann das nanoelektronische Bauelement erzeugt werden, indem die Schicht mit Hilfe eines Rasterkraftmikroskops teilweise oxidiert wird, wie es z.B. in K. Matsumoto, "STM/AFM Nano-Oxidation Process to Room-Temperature-Operated Single-Electron Transistor and Other Devices", Proc. IEEE 85, 612 (1997) erläutert wird.

Für die Erfindung ist der Aufbau des nanoelektronischen Bauelements irrelevant. So kann das nanoelektronische Bauelement z.B. eine biologische Nervenzelle, eine molekularelektronische Struktur z.B. gemäß C.M. Fischer et al (s.o.), ein CMOS-Bauelement gemäß F.G. Pikus et al (s.o.) oder eine Speicherzelle gemäß K. Yano et al (s.o.) sein.

Das nanoelektronische Bauelement kann Körner aus leitendem Material aufweisen, die von isolierendem Material umhüllt sind. Einzelne Elektronen können von Korn zu Korn tunneln.

Im folgenden wird ein Ausführungsbeispiel der Erfindung anhand der Figur näher erläutert.

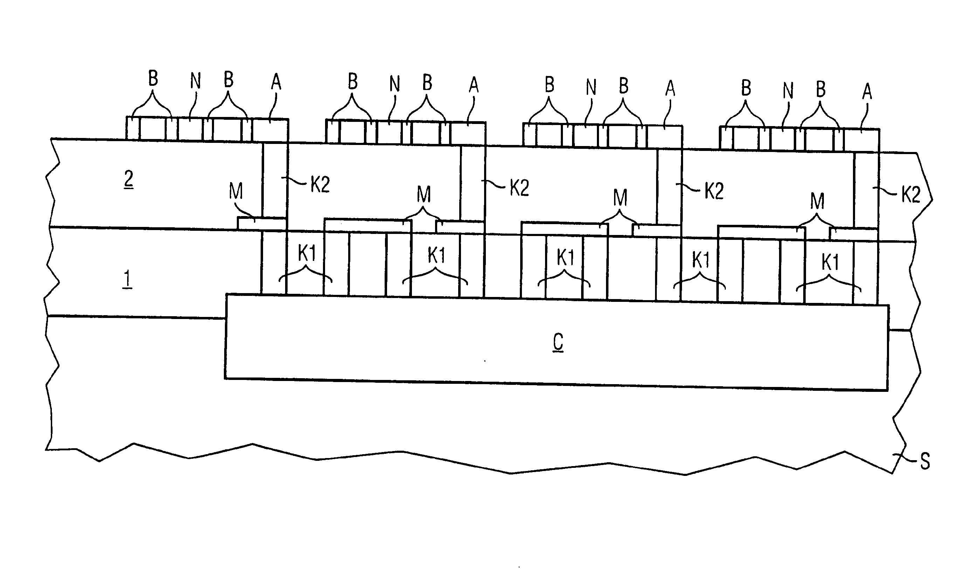

- Figur 1: zeigt einen Speicher, der ein Substrat mit einer CMOS-Ansteuerlogik, eine isolierende Schicht mit mehreren Metallisierungsebenen und Kontakten und Speicherzellen-Anordnungen, die in Form von Nano-Schaltblöcken realisiert sind, umfaßt.

In einem Ausführungsbeispiel ist als Ausgangsmaterial ein Substrat S aus Silizium vorgesehen. Durch ein herkömmliches CMOS-Verfahren wird im Substrat S eine CMOS-Ansteuerlogik C erzeugt.

Anschließend wird ein erster Teil 1 einer isolierenden Schicht erzeugt, indem SiO₂ in einer Dicke von ca. 1500 nm abgeschieden und durch chemisch-mechanisches Polieren planarisiert wird.

Durch ein photolithographisches Verfahren werden Kontaktlöcher in den ersten Teil 1 der isolierenden Schicht erzeugt. Die Kontaktlöcher werden mit Wolfram gefüllt, so daß erste Kontakte K1 erzeugt werden.

Durch Abscheiden und Strukturieren von Aluminium wird eine Metallisierungsebene M erzeugt, die mit den ersten Kontakten K1 verbunden ist.

Zur Erzeugung eines zweiten Teils 2 der isolierenden Schicht wird SiO₂ in einer Dicke von ca. 1000 nm abgeschieden und durch chemisch-mechanisches Polieren planarisiert. Durch ein photolithographisches Verfahren werden Kontaktlöcher in den zweiten Teil 2 der isolierenden Schicht erzeugt, so daß Teile der Metallisierungsebene M freigelegt werden. Anschließend werden die Kontaktlöcher mit Wolfram gefüllt, so daß zweite Kontakte K2 erzeugt werden.

Zur Erzeugung einer Schicht aus Titan wird Titan in einer Dicke von ca. 3 nm abgeschieden. Zur Erzeugung von Tunnelbarrieren und Isolationsstegen wird die Schicht aus Titan mit Hilfe eines Rasterkraftmikroskops (AFM) lokal oxidiert. An Spitze und dem damit verbundenen Cantilever des AFM, die leitfähig sind, wird dazu eine Spannung von -10V gegenüber der Schicht aus Titan angelegt. Die Oxidation ist anodisch und erfolgt mit Hilfe eines H₂O-Films, der auf der Schicht aus Titan und der Spitze des AFM adsorbiert wird.

Aus der Schicht aus Titan entstehen dadurch Nano-Schaltblöcke N, die jeweils Speicherzellen umfassen, die mit ca. 10 nm breiten Bitleitungen B und Wortleitungen verbunden sind (in Figur 1 schematisch dargestellt). Aus der Schicht aus Titan werden ferner Nano-Ansteuerschaltungen A erzeugt, die die Bitleitungen B und die Wortleitungen so zusammenfassen, daß ihre Signale sequentiell an die CMOS-Ansteuerlogik C weitergeleitet werden.

Die Metallisierungsebene M, die ersten Kontakte K1 und die zweiten Kontakte K2 bilden leitende Strukturen, die der Verbindung zwischen den Nano-Schaltblöcken N und der CMOS-Ansteuerlogik C dienen.

## Patentansprüche

1. Schaltungsanordnung mit mindestens einem nanoelektronischen Bauelement, bei der
- mindestens ein CMOS-Bauelement Teil der Schaltungsanordnung ist und in einem Halbleitersubstrat (S) angeordnet ist,
- auf dem Halbleitersubstrat (S) eine isolierende Schicht (1, 2) angeordnet ist, die das CMOS-Bauelement bedeckt,
- über der isolierenden Schicht (1, 2) das nanoelektronische Bauelement angeordnet ist,
- in der isolierenden Schicht (1, 2) mindestens eine leitende Struktur angeordnet ist, die der Verbindung des nanoelektronischen Bauelements mit dem CMOS-Bauelement dient,
- über der isolierenden Schicht (1, 2) weitere nanoelektronische Bauelemente angeordnet sind, die zu Nano-Schaltblöcken (N) gruppiert sind, wobei die Nano-Schaltblöcke (N) jeweils so klein sind, dass RC-Zeiten ihrer Leitungen (B) nicht größer als 1 ns sind,
- jeder Nano-Schaltblock (N) Leitungen (B) umfasst, die die nanoelektronischen Bauelemente des Nano-Schaltblocks (N) untereinander verbinden,
- das CMOS-Bauelement Teil einer CMOS-Schaltung (C) ist, die im Halbleitersubstrat (S) angeordnet ist,
- die CMOS-Schaltung (C) eine erste Ansteuerschaltung für die Nano-Schaltblöcke (N) ist,
- an jeden Nano-Schaltblock (N) eine zweite Ansteuerschaltung (A) auf der isolierenden Schicht (1, 2) angrenzt, wobei die Ansteuerschaltung (A) zwischen den Nano-Schaltblock (N) und die CMOS-Schaltung (CC) geschaltet ist, und
- die leitenden Strukturen die CMOS-Schaltung (C) mit den zweiten Ansteuerschaltungen (A) verbinden,
- die zweite Ansteuerschaltung (A) die Leitungen (B) im Nano-Schaltblock (N) so zusammenfasst, dass die Zahl der leitenden Strukturen, die mit der zweiten Ansteuerschaltung (A) verbunden sind, kleiner ist als die Zahl der Leitungen (B) im Nano-Schaltblock (N).

2. Schaltungsanordnung nach Anspruch 1,
**dadurch gekennzeichnet, daß**
- die Nano-Schaltblöcke (N) jeweils über mindestens eine in der isolierenden Schicht (1, 2) angeordnete leitende Struktur mit der CMOS-Schaltung (C) verbunden sind,
- das nanoelektronische Bauelement Teil eines der Nano-Schaltblöcke (N) ist, und
- mindestens eine der Leitungen (B) des Nano-Schaltblocks (N) der Verbindung des nanoelektronischen Bauelements mit der leitenden Struktur dient.

3. Schaltungsanordnung nach Anspruch 1 oder 2,
**dadurch gekennzeichnet, daß**
- in der isolierenden Struktur (1, 2) mindestens eine Metallisierungsebene (M) angeordnet ist, die Teil der leitenden Strukturen ist,
- Kontakte (K1, K2) Teile der leitenden Strukturen sind, und
- die Kontakte (K1, K2) in der isolierenden Schicht (1, 2) angeordnet sind und jeweils die CMOS-Schaltung (C) mit der Metallisierungsebene (M) oder die Metallisierungsebene (M) mit den zweiten Ansteuerschaltungen (A) verbinden.

4. Schaltungsanordnung nach einem der Ansprüche 1 bis 3,
**dadurch gekennzeichnet, daß**
das nanoelektronische Bauelement größtenteils aus Aluminium, Titan oder Niob besteht.

5. Schaltungsanordnung nach einem der Ansprüche 1 bis 4,
**dadurch gekennzeichnet, daß**
die Nano-Schaltblöcke (N) Speicherzellen-Anordnungen sind.

6. Verfahren zur Herstellung einer Schaltungsanordnung nach einem der Ansprüche 1 bis 5,
wobei
- in einem Halbleitersubstrat (S) mit einem CMOS-Verfahren mindestens ein CMOS-Bauelement erzeugt wird, das Teil der Schaltungsanordnung ist,
- nach Erzeugung des CMOS-Bauelements eine isolierende Schicht (1, 2) auf dem Halbleitersubstrat (S) aufgebracht wird, die das CMOS-Bauelement bedeckt,
- in der isolierenden Schicht (1, 2) eine leitende Struktur erzeugt und mit dem CMOS-Bauelement verbunden wird,
- über der isolierenden Schicht (1, 2) mit einer Nano-Strukturierungstechnik das nanoelektronische Bauelement so erzeugt wird, daß es über die leitende Struktur mit dem CMOS-Bauelement verbunden ist
- über der isolierenden Schicht (1, 2) weitere nanoelektronische Bauelemente so erzeugt werden, dass sie zu Nano-Schaltblöcken (N) gruppiert sind, wobei die Nano-Schaltblöcke (N) jeweils so klein sind, dass RC-Zeiten ihrer Leitungen (B) nicht größer als 1 ns sind,
- in jedem Nano-Schaltblock (N) Leitungen (B) erzeugt werden, die die nanoelektronischen Bauelemente des Nano-Schaltblocks (N) untereinander verbinden,
- das CMOS-Bauelement als Teil einer CMOS-Schaltung (C) erzeugt wird, die im Halbleitersubstrat (S) angeordnet ist,
- die CMOS-Schaltung (C) so erzeugt wird, dass diese eine erste Ansteuerschaltung für die Nano-Schaltblöcke (N) ist,
- zweite Ansteuerschaltungen (A) so erzeugt werden, dass an jeden Nano-Schaltblock (N) eine zweite Ansteuerschaltung auf der isolierenden Schicht (1, 2) angrenzt, wobei die Ansteuerschaltung (A) zwischen den Nano-Schaltblock (N) und die CMOS-Schaltung (CC) geschaltet ist, und
- die leitenden Strukturen so erzeugt werden, dass diese die CMOS-Schaltung (C) mit den zweiten Ansteuerschaltungen (A) verbinden,
- die zweite Ansteuerschaltung (A) so erzeugt wird, dass diese die Leitungen (B) im Nano-Schaltblock (N) so zusammenfasst, dass die Zahl der leitenden Strukturen, die mit der zweiten Ansteuerschaltung (A) verbunden sind, kleiner ist als die Zahl der Leitungen (B) im Nano-Schaltblock

7. Verfahren nach Anspruch 6,
**dadurch gekennzeichnet, daß**
über der isolierenden Schicht (1, 2) mindestens eine Schicht aufgebracht wird, in der das nanoelektronische Bauelement erzeugt wird.

8. Verfahren nach Anspruch 6 oder 7,
**dadurch gekennzeichnet, daß**
- in der isolierenden Schicht (1,2) weitere leitende Strukturen erzeugt werden, so daß die Nano-Schaltblöcke (N) über die leitende Struktur und die weiteren leitenden Strukturen mit der CMOS-Schaltung (C) verbunden sind,
- das nanoelektronische Bauelement als Teil eines der Nano-Schaltblöcke (N) erzeugt wird,
- mindestens eine der Leitungen (B) des Nano-Schaltblocks (N) so erzeugt wird, daß sie der Verbindung des nanoelektronischen Bauelements mit der leitenden Struktur dient.

9. Verfahren nach Anspruch 8,
**dadurch gekennzeichnet, daß**
- zunächst ein unterer Teil (1) der isolierenden Schicht aufgebracht wird, in dem als Teile der leitenden Strukturen erste Kontakte (K1) erzeugt werden, die an die CMOS-Schaltung (C) angrenzen,
- auf dem unteren Teil (1) der isolierenden Schicht als Teil der leitenden Strukturen eine Metallisierungsebene (M) erzeugt wird, die mit den ersten Kontakten (K1) verbunden wird,
- ein oberer Teil (2) der isolierenden Schicht aufgebracht wird, in dem als Teile der leitenden Strukturen zweite Kontakte (K2) erzeugt werden, die mit der Metallisierungsebene (M) verbunden werden, und
- die Nano-Schaltblöcke mit den zweiten Kontakten verbunden werden.

10. Verfahren nach einem der Ansprüche 7 bis 9,
**dadurch gekennzeichnet, daß**
die Schicht Aluminium, Titan oder Niob enthält.

## Claims

1. Circuit arrangement having at least one nanoelectronic component, in which
- at least one CMOS component is part of the circuit arrangement and is arranged in a semiconductor substrate (S),
- an insulating layer (1, 2), which covers the CMOS component, is arranged on the semiconductor substrate (S),
- the nanoelectronic component is arranged above the insulating layer (1, 2),
- at least one conductive structure is arranged in the insulating layer (1, 2), which structure serves for connecting the nanoelectronic component to the CMOS component,
- further nanoelectronic components are arranged above the insulating layer (1, 2), which components are grouped into nano-switching blocks (N), the nano-switching blocks (N) each being so small that RC times of their lines (B) are not longer than 1 ns,
- each nano-switching block (N) comprises lines (B) which interconnect the nanoelectronic components of the nano-switching block (N),
- the CMOS component is part of a CMOS circuit (C) arranged in the semiconductor substrate (S),
- the CMOS circuit (C) is a first drive circuit for the nano-switching blocks (N),
- each nano-switching block (N) is adjoined by a second drive circuit (A) on the insulating layer (1, 2), the drive circuit (A) being connected between the nano-switching block (N) and the CMOS circuit (C), and
- the conductive structures connect the CMOS circuit (C) to the second drive circuits (A),
- the second drive circuit (A) combines the lines (B) in the nano-switching block (N) in such a way that the number of conductive structures connected to the second drive circuit (A) is less than the number of lines (B) in the nano-switching block (N).

2. Circuit arrangement according to Claim 1,
**characterized in that**
- the nano-switching blocks (N) are each connected to the CMOS circuit (C) via at least one conductive structure arranged in the insulating layer (1, 2),
- the nanoelectronic component is part of one of the nano-switching blocks (N), and
- at least one of the lines (B) of the nano-switching block (N) serves for connecting the nanoelectronic component to the conductive structure.

3. Circuit arrangement according to Claim 1 or 2,
**characterized in that**
- at least one metallization plane (M), which is part of the conductive structures, is arranged in the insulating structure (1, 2),
- contacts (K1, K2) are parts of the conductive structures, and
- the contacts (K1, K2) are arranged in the insulating layer (1, 2) and in each case connect the CMOS circuit (C) to the metallization plane (M) or the metallization plane (M) to the second drive circuits (A).

4. Circuit arrangement according to one of Claims 1 to 3,
**characterized in that**
the nanoelectronic component for the most part comprises aluminum, titanium or niobium.

5. Circuit arrangement according to one of Claims 1 to 4,
**characterized in that** the nano-switching blocks (N) are memory cell arrangements.

6. Method for fabricating a circuit arrangement according to one of Claims 1 to 5,
wherein
- at least one CMOS component, which is part of the circuit arrangement, is produced in a semiconductor substrate (S) by means of a CMOS method,
- after production of the CMOS component, an insulating layer (1, 2) is applied on the semiconductor substrate (S), which layer covers the CMOS component,
- a conductive structure is produced in the insulating layer (1, 2) and connected to the CMOS component,
- the nanoelectronic component is produced above the insulating layer (1, 2) by means of a nano-pattering technique in such a way that it is connected to the CMOS component via the conductive structure,
- further nanoelectronic components are produced above the insulating layer (1, 2) in such a way that they are grouped into nano-switching blocks (N), the nano-switching blocks (N) each being so small that RC times of their lines (B) are not longer than 1 ns,
- in each nano-switching block (N), lines (B) are produced which interconnect the nanoelectronic components of the nano-switching block (N),
- the CMOS component is produced as part of a CMOS circuit (C) arranged in the semiconductor substrate (S),
- the CMOS circuit (C) is produced in such a way that it is a first drive circuit for the nano-switching blocks (N),
- second drive circuits (A) are produced in such a way that each nano-switching block (N) is adjoined by a second drive circuit on the insulating layer (1, 2), the drive circuit (A) being connected between the nano-switching block (N) and the CMOS circuit (CC), and
- the conductive structures are produced in such a way that they connect the CMOS circuit (C) to the second drive circuits (A),
- the second drive circuit (A) is produced in such a way that it combines the lines (B) in the nano-switching block (N) in such a way that the number of conductive structures connected to the second drive circuit (A) is less than the number of lines (B) in the nano-switching block.

7. Method according to Claim 6,
**characterized in that** at least one layer is applied above the insulating layer (1, 2) and the nanoelectronic component is produced in it.

8. Method according to Claim 6 or 7,
**characterized in that**
- further conductive structures are produced in the insulating layer (1, 2), so that the nano-switching blocks (N) are connected to the CMOS circuit (C) via the conductive structure and the further conductive structures,
- the nanoelectronic component is produced as part of one of the nano-switching blocks (N),
- at least one of the lines (B) of the nano-switching block (N) is produced in such a way that it serves for connecting the nanoelectronic component to the conductive structure.

9. Method according to Claim 8,
**characterized in that**
- firstly a lower part (1) of the insulating layer is applied, in which part first contacts (K1) adjoining the CMOS circuit (C) are produced as parts of the conductive structures,
- a metallization plane (M) is produced on the lower part (1) of the insulating layer as part of the conductive structures, which metallization plane is connected to the first contacts (K1),
- an upper part (2) of the insulating layer is applied, in which part second contacts (K2) connected to the metallization plane (M) are produced as parts of the conductive structures, and
- the nano-switching blocks are connected to the second contacts.

10. Method according to one of Claims 7 to 9,
**characterized in that**
the layer contains aluminum, titanium or niobium.

## Revendications

1. Circuit comportant au moins un composant nanoélectronique, dans lequel
- au moins un composant CMOS fait partie du circuit et est agencé dans un substrat semi-conducteur (S),
- une couche isolante (1, 2) qui recouvre le composant CMOS est agencée sur le substrat semi-conducteur (S),
- le composant nanoélectronique est agencé au-dessus de la couche isolante (1, 2),
- au moins une structure conductrice, qui sert à la liaison du composant nanoélectronique avec le composant CMOS, est agencée dans la couche isolante (1, 2),
- d'autres composants nanoélectroniques qui sont groupés en nanoblocs de commutation (N) sont agencés au-dessus de la couche isolante (1, 2), les nanoblocs de commutation (N) étant chacun si petits que les temps RC de leurs lignes (B) ne sont pas supérieurs à 1 ns,
- chaque nanobloc de commutation (N) comprend des lignes (B) qui relient entre eux les composants nanoélectroniques du nanobloc de commutation (N),
- le composant CMOS fait partie d'un circuit CMOS (C) qui est agencé dans le substrat semi-conducteur (S),
- le circuit CMOS (C) est un premier circuit de commande pour les nanoblocs de commutation (N),
- un deuxième circuit de commande (A) sur la couche isolante (1, 2) est adjacent à chaque nanobloc de commutation (N), le circuit de commande (A) étant branché entre le nanobloc de commutation (N) et le circuit CMOS (CC), et
- les structures conductrices relient le circuit CMOS (C) aux deuxièmes circuits de commande (A),
- le deuxième circuit de commande (A) réunit les lignes (B) dans le nanobloc de commutation (N) de telle sorte que le nombre des structures conductrices qui sont reliées au deuxième circuit de commande (A) est plus petit que le nombre des lignes (B) dans le nanobloc de commutation (N).

2. Circuit selon la revendication 1,
**caractérisé par le fait que**
- les nanoblocs de commutation (N) sont reliés au circuit CMOS (C) par l'intermédiaire d'au moins une structure conductrice agencée dans la couche isolante (1, 2),
- le composant nanoélectronique fait partie de l'un des nanoblocs de commutation (N), et
- au moins l'une des lignes (B) du nanobloc de commutation (N) sert à la liaison du composant nanoélectronique avec la structure conductrice.

3. Circuit selon la revendication 1 ou 2,
**caractérisé par le fait que**
- au moins un plan de métallisation (M) qui fait partie des structures conductrices est agencé dans la structure isolante (1, 2),
- des contacts (K1, K2) font partie des structures conductrices, et
- les contacts (K1, K2) sont agencés dans la couche isolante (1, 2) et relient respectivement le circuit CMOS (C) au plan de métallisation (M) ou le plan de métallisation (M) aux deuxièmes circuits de commande (A).

4. Circuit selon l'une des revendications 1 à 3,
**caractérisé par le fait que** le composant nanoélectronique est constitué en majeure partie d'aluminium, de titane ou de niobium.

5. Circuit selon l'une des revendications 1 à 4,
**caractérisé par le fait que** les nanoblocs de commutation (N) sont des agencements de cellules de mémoire.

6. Procédé pour la fabrication d'un circuit selon l'une des revendications 1 à 5, dans lequel
- avec un procédé CMOS, on produit dans un substrat semi-conducteur (S) au moins un composant CMOS qui fait partie du circuit,
- après la production du composant CMOS, on applique sur le substrat semi-conducteur (S) une couche isolante (1, 2) qui recouvre le composant CMOS,
- on produit une structure conductrice dans la couche isolante (1, 2) et on la relie au composant CMOS,
- avec une technique de nanostructuration, on produit le composant nanoélectronique au-dessus de la couche isolante (1, 2) de telle sorte qu'il est relié au composant CMOS par l'intermédiaire de la structure conductrice,
- on produit d'autres composants nanoélectroniques au-dessus de la couche isolante (1, 2) de telle sorte qu'ils sont regroupés en nanoblocs de commutation (N), les nanoblocs de commutation (N) étant chacun si petits que les temps RC de leurs lignes (B) ne sont pas supérieurs à 1 ns,
- on produit dans chaque nanobloc de commutation (N) des lignes (B) qui relient entre eux les composants nanoélectroniques du nanobloc de commutation (N),
- on produit le composant CMOS en tant que partie d'un circuit CMOS (C) qui est agencé dans le substrat semi-conducteur (S),
- on produit le circuit CMOS (C) de telle sorte qu'il est un premier circuit de commande pour les nanoblocs de commutation (N),
- on produit des deuxièmes circuits de commande (A) de telle sorte que, sur la couche isolante (1, 2), un deuxième circuit de commande est adjacent à chaque nanobloc de commutation (N), le circuit de commande (A) étant branché entre le nanobloc de commutation (N) et le circuit CMOS (CC), et
- on produit les structures conductrices de telle sorte qu'elles relient le circuit CMOS (C) aux deuxièmes circuits de commande (A),
- on produit le deuxième circuit de commande (A) de telle sorte qu'il réunit les lignes (B) dans le nanobloc de commutation (N) de telle sorte que le nombre des structures conductrices qui sont reliées au deuxième circuit de commande (A) est plus petit que le nombre des lignes (B) dans le nanobloc de commutation.

7. Procédé selon la revendication 6,
**caractérisé par le fait que** l'on applique au-dessus de la couche isolante (1, 2) au moins une couche dans laquelle on produit le composant nanoélectronique.

8. Procédé selon la revendication 6 ou 7,
**caractérisé par le fait que**
- on produit d'autres structures conductrices dans la couche isolante (1, 2) de telle sorte que les nanoblocs de commutation (N) sont reliés au circuit CMOS (C) par l'intermédiaire de la structure conductrice et des autres structures conductrices,
- on produit le composant nanoélectronique en tant que partie des nanoblocs de commutation (N), et
- on produit au moins l'une des lignes (B) du nanobloc de commutation (N) de telle sorte qu'elle sert à la liaison du composant nanoélectronique avec la structure conductrice.

9. Procédé selon la revendication 8,
**caractérisé par le fait que**
- on applique d'abord une partie inférieure (1) de la couche isolante dans laquelle on produit en tant que partie des structures conductrices des premiers contacts (K1) qui sont adjacents au circuit CMOS (C),
- on produit sur la partie inférieure (1) de la couche isolante, en tant que partie des structures conductrices, un plan de métallisation (M) qui est relié aux premiers contacts (K1),
- on applique une partie supérieure (2) de la couche isolante dans laquelle on produit en tant que partie des structures conductrices des deuxièmes contacts (K2) qui sont reliés au plan de métallisation (M), et
- on relie les nanoblocs de commutation aux deuxièmes contacts.

10. Procédé selon l'une des revendications 7 à 9,
**caractérisé par le fait que** la couche contient de l'aluminium, du titane ou du niobium.
